Europäisches Patentamt

European Patent Office

Office européen des brevets

(11) Publication number: **0 113 517**
**. B1**

(12) **EUROPEAN PATENT SPECIFICATION**

(45) Date of publication of patent specification: **17.01.90**

(51) Int. Cl.⁵: **H 01 L 21/32,** H 01 L 21/308, H 01 L 21/76

(21) Application number: **83307091.5**

(22) Date of filing: **21.11.83**

(54) Method for forming an isolation region.

(30) Priority: **29.11.82 JP 209172/82**
**29.11.82 JP 209173/82**

(43) Date of publication of application:
**18.07.84 Bulletin 84/29**

(45) Publication of the grant of the patent:
**17.01.90 Bulletin 90/03**

(84) Designated Contracting States:
**DE FR GB**

(56) References cited:
EP-A-0 074 541     GB-A-2 083 947
EP-A-0 076 942     US-A-4 282 647
DE-A-3 023 410     US-A-4 390 393
FR-A-2 204 045     US-A-4 422 897

IEEE TRANSACTIONS ON ELECTRON DEVICES,
vol. ED-28, no. 11, November 1981, pages
1320-1323, IEEE, New York, US; C.M. HORWITZ:
"Reactive sputter etching of silicon with very
low mask-material etch rates"

(73) Proprietor: **FUJITSU LIMITED**
**1015, Kamikodanaka Nakahara-ku**
**Kawasaki-shi Kanagawa 211 (JP)**

(72) Inventor: **Fukano, Tetsu**
**2791, Kishi Yamakitamachi**
**Ashigarakami-gun Kanagawa 258-01 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to a method for forming an isolation region for electrically isolating elements of a semiconductor device, more particularly, to a method for forming an isolation region by which a semiconductor device having a high integration density can be produced.

It is well known that an isolation region, i.e., a region for isolating elements from each other, can be formed by the steps of forming a silicon nitride ($Si_3N_4$) layer on a silicon substrate, patterning the silicon nitride, and then forming a silicon dioxide layer by thermal oxidation of the surface of the silicon substrate using the patterned silicon nitride layer as a masking film.

In the above-mentioned processes, however, particularly in the thermal oxidation of the surface of the silicon substrate, the silicon layer located below the edge portion of the silicon nitride layer is simultaneously oxidized. The resultant silicon dioxide layer raises the edge portion of the silicon nitride layer. This silicon dioxide layer, commonly called a "bird's beak" due to its configuration, extends to the active region and therefore decreases the possible integration density.

In an improved method for forming an isolation region, grooves are formed in the surface portion of the silicon substrate by a photolithography technique. Thermal oxidation or a chemical vapor deposition (CVD) process is then used to form an insulating layer on the grooves, thereby effecting element isolation. The smallest possible width of the grooves formed in the surface of the silicon substrate, namely, the width of the isolation region, is presently at least 1 µm due to limitations of the photolithography process. It has not been possible until now to form submicron-width isolation regions.

According to a first aspect of the present invention, there is provided a method for forming an isolation region for electrically isolating elements in a semiconductor substrate, comprising the steps of:

forming a metal or a metal silicide layer on said semiconductor substrate;

forming a resist layer on said metal or metal silicide layer;

forming an edge of the resist layer by patterning of the resist layer;

selectively etching said metal or metal silicide layer and said ·semiconductor substrate by a reactive ion etching process using a mixture of chlorine-containing gas and oxygen gas, the relative proportions of chlorine-containing gas and oxygen gas being such that first only the metal or metal silicide layer located around the edge of the resist layer is etched, and then only the surface of the semiconductor substrate located around the edge of the resist layer is etched so as to form a groove in the surface portion of said semiconductor substrate located around the edge of said resist layer; and

forming an insulating layer in said groove.

According to a second aspect a method for forming an isolation region for electrically isolating elements in a semiconductor substrate comprising the steps of:

forming in turn, a first insulating layer, a metal or a metal silicide layer, and resist layer;

forming an edge of the resist layer by patterning of the resist layer;

then, selectively etching said metal or metal silicide layer by a reactive ion etching process using a mixture of chlorine-containing gas and oxygen gas, the relative proportions of chlorine-containing gas and oxygen gas being such that only the metal or metal silicide layer located around the edge of the resist layer is etched to form a groove in the metal or metal silicide layer,

etching said first insulating layer using said metal or metal silicide layer as a masking film;

etching said semiconductor substrate using said patterned insulating layer as a masking film to form a groove in the surface portion of said semiconductor substrate; and

forming a second insulating layer in said groove.

An embodiment of the present invention can provide a method for forming an isolation region having an submicron width.

An embodiment of the present invention can also provide a method for forming an isolation region which does not require a fine photolithography process.

An embodiment of the present invention can also provide a method for forming isolation regions for semiconductor devices such as bipolar transistors or metal oxide semiconductor (MOS) transistors, allowing a high integration density.

Reference is made, by way of example, to the accompanying drawings, wherein:

Figures 1A to 1D are schematic cross-sectional views for explaining a method according to the present invention;

Figs. 2A to 2F are schematic cross-sectional views for explaining another method according to the present invention;

Fig. 3 is a graph of the relationship between the percentage of oxygen in a gas mixture and the etching rate;

Fig. 4 is a graph of the relationship between the etching time and etching width;

Fig. 5 is a schematic cross-sectional view for explaining an alternative method for forming an isolation region in a groove;

Fig. 6 is a schematic cross-sectional view for explaining another alternative method for forming an isolation region in a groove;

Figs. 7A to 7C are schematic cross-sectional views for explaining still another alternative method for forming an isolation region in a groove;

Fig. 8 is a view for explaining an application of the present invention to a bipolar transistor;

Fig. 9 is a view for explaining an application of the present invention to an n type MOS transistor;

Figs. 10A to 10D are views for explaining an application of the present invention to a complementary MOS (CMOS) transistor.

A method according to the present invention for forming an isolation region for electrically isolating elements in a semiconductor substrate, comprises the steps of the method as claimed in claim 1.

It is preferable that the metal be selected from the group consisting of molybdenum, tungsten, titanium, platinum, and tantalum; that the metal silicide be selected from the group consisting of molybdenum silicide, tungsten silicide, titanium silicide, platinum silicide, and tantalum silicide, and that the chlorine-containing gas be selected from the group consisting of carbon tetrachloride, silicon tetrachloride and boron tetrachloride.

The reactive ion etching can be advantageously carried out using a mixed gas (gas mixture) of oxygen and carbon tetrachloride at a power density of 0.14 to 0.35 W/cm² and degree of vacuum (pressure) of 1 to 10 Pa, for 1 to 9 or 3 to 30 minutes, the volume percentage of oxygen in the mixed gas of oxygen and the carbon tetrachloride being 60% to 70%.

The insulating layer in the groove is preferably formed by a thermal oxidation process at a temperature of 800°C to 1100°C under a wet oxidation atmosphere or by a CVD process or, further, by the steps comprising oxidizing the whole inner wall of the groove by the thermal oxidation process; burying the groove in polycrystalline silicon by a CVD process. The exposed surface of polycrystalline silicon in said groove may be oxidised by thermal oxidation.

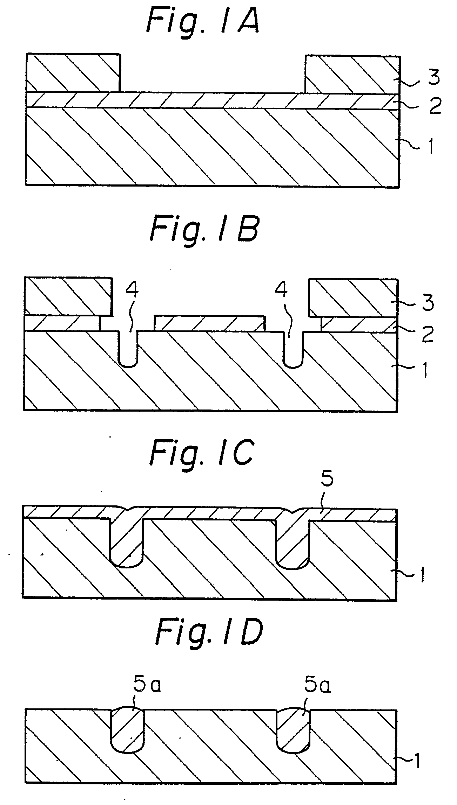

Figures 1A to 1D are schematic cross-sectional views for explaining an example of steps according to the present invention.

As shown in Fig. 1A, a molybdenum silicide (MoSi₂) layer 2 about 0.3 μm thick, is formed on a silicon substrate 1 by the D.C. magnetron sputtering process. A resist layer 3, for example, AZ—1350J of SHIPLEY Co., is formed on the molybdenum silicide layer 2 at a thickness of approximately 1.8 μm by the well-known spinning process. The resist layer 3 is then patterned to obtain a required form.

As shown in Fig. 1B, the molybdenum silicide layer 2 and the silicon substrate 1 are etched by the reactive ion etching process. The reactive ion etching process is carried out by using a gas mixture of 70% oxygen and 30% carbon tetrachloride; at a power density of 0.28 W/cm², a pressure of 4 Pa, and an etching time of 9 minutes. In the etching process, the molybdenum silicide layer 2 located around the edge of the resist layer 3 is first etched; then the surface of the silicon substrate 1 located around the edge of the resist layer 3 is etched so as to make grooves 4 having a width of 0.3 μm and a depth of 0.8 μm. Note that peripheral etching is carried out so that the edge of the resist must be positioned at a required pattern.

As shown in Fig. 1C, the resist layer 3 and the molybdenum silicide layer 2 are then removed by the oxygen plasma ashing and wet etching processes respectively.

Thermal oxidation is then effected at a temperature of 1000°C under a wet oxygen atmosphere to form a silicon dioxide (SiO₂) layer 5 having a thickness of approximately 0.3 μm over the silicon substrate 1, which thickness is the same level as the width of the prior grooves 4. The width of the silicon dioxide layer formed in the grooves is approximately 0.6 μm, twice the width of the grooves.

As shown in Fig. 1D, the silicon dioxide layer 5 over the top surface of silicon substrate 1 is removed by the normal wet etching process, leaving the silicon dioxide in the grooves 4 as buried silicon dioxide regions 5a. The surface of the buried silicon dioxide regions 5a is substantially flat. The silicon dioxide regions 5a act as isolation regions for a variety of semiconductor devices. Alternative processes for forming isolation regions in the grooves will be described later.

Another method according to the present invention for forming an isolation region for electrically isolating elements in a semiconductor substrate, comprises the steps of the method as claimed in claim 7.

The same preferable constituents and conditions as in the first method apply to this second method. The first insulating layer is preferably composed of either silicon nitride or silicon dioxide. The etching of the metal or metal silicide layer is advantageously carried out by a reactive ion etching process using a mixture of oxygen and carbon tetrachloride at a power density of 0.14 to 0.35 W/cm² and a pressure of 1 to 10 Pa, for 1 to 9 minutes, the volume percentage of oxygen in the mixture being 60% to 70%. The etching of the first insulating layer to form the groove is advantageously carried out by a reactive ion etching process using an etching gas of trifluoromethane at a power density of 0.06 to 0.8 W/cm² and pressure of 0.9 to 13 Pa, for 3 to 30 minutes.

The etching of the semiconductor substrate can be carried out by a reactive ion etching process using a mixture of oxygen and carbon tetrachloride at a power density of 0.14 to 0.35 W/cm² and a pressure of 1 to 10 Pa, for 3 to 30 minutes, the volume percentage of oxygen in the mixture being less than 50. The second insulating layer can be formed in the same ways as described for the insulating layer of the first method.

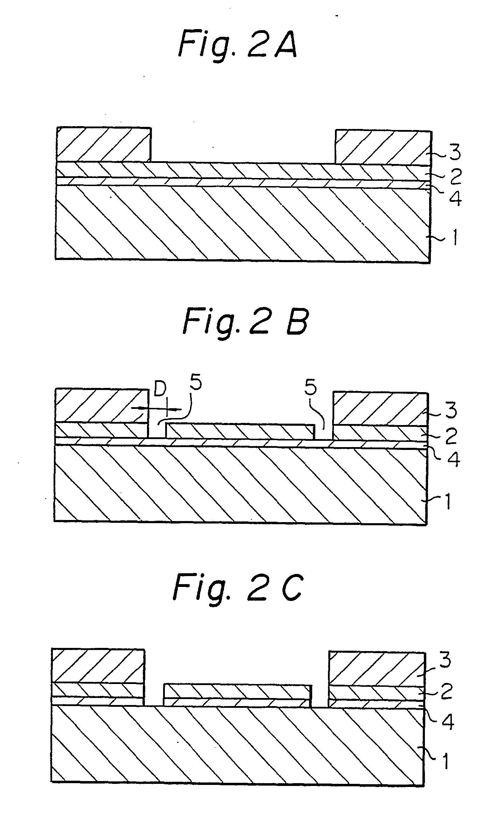

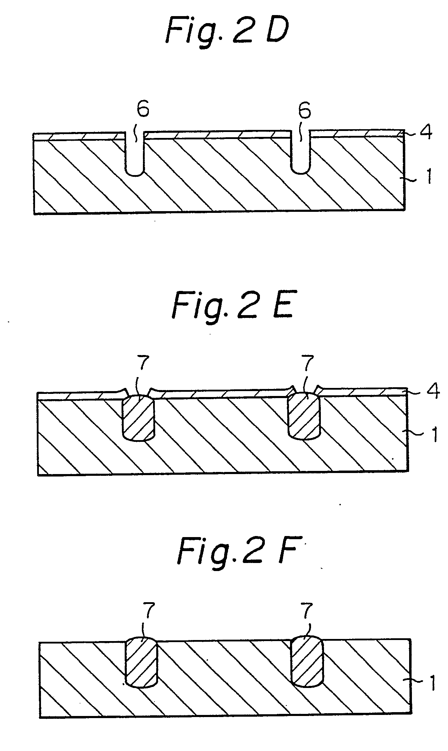

Figures 2A to 2F are schematic cross-sectional views for explaining an example of steps according to this other method according to the present invention.

As shown in Fig. 2A an insulating layer 4 about 0.1 μm thick and consisting of, for example, silicon nitride (Si₃N₄) is formed on a silicon substrate 1 by the CVD process. Then, a metal silicide layer 2 about 0.3 μm thick and consisting of, for example, molybdenum silicide is formed on the insulating layer 4 by the D.C. magnetron sputtering process. A resist layer 3, for example, AZ—1350J of SHIPLEY Co., is formed on the metal silicide layer 2 at a thickness of approximately 1.8 μm by the well known spinning process. The resist layer 3 is then patterned to give it the required form.

As shown in Fig. 2B, the metal silicide layer 2 located around the edge of the resist layer 3 is then etched by the reactive ion etching process to form grooves 5. The reactive ion etching process is carried out under the same etching conditions as in Fig. 1B. The resulting grooves 5 have a width D of 0.2 to 0.3 µm.

As shown in Fig. 2C, the etching gas in the parallel-plate-type reactive ion etching apparatus is then changed to trifluoromethane ($CHF_3$), and the exposed insulating layer 4 is etched by the reactive ion etching process under a power density of 0.16 $W/cm^2$, a pressure of 6.7 Pa, and an etching time of 15 minutes, using patterned metal silicide layer 2 and resist layer 3 as a mask.

As shown in Fig. 2D, the resist layer 3 is then removed by the ashing process. The etching gas in the parallel-plate-type reactive ion etching apparatus is changed to a gas which will etch the metal silicide layer 2 and the silicon substrate 1 but not easily etch the insulating layer 4, for example a mixture by volume of 20% oxygen and 80% carbon tetrachloride, and etching is conducted at a power density of 0.28 $W/cm^2$, pressure of 4 Pa, and an etching time of 5 minutes. This removes the metal silicide layer 2, and grooves 6 having a width of approximately 0.2 to 0.3 µm are formed in the silicon substrate 1 to a depth of approximately 0.7 µm.

As shown in Fig. 2E, thermal oxidation is then effected at a temperature of 1000°C under a wet oxidizing atmosphere to form an insulating layer 7 consisting of silicon dioxide, which acts as an isolation region. The width of the silicon dioxide layer formed in the groove is approximately 0.4 to 0.6 µm, twice the width of the grooves 6.

Subsequently, as shown in Fig. 2F, the insulating layer 4 at the surface is removed by a wet etching process using phosphoric acid at 180°C to leave isolation regions in the grooves of submicron width.

Alternative processes for forming isolation regions in the grooves are described later.

In order to obtain grooves with a submicron width in the silicon substrate 1 located around the edge of the resist layer 3, by the reactive ion etching process using a mixed gas of oxygen and carbon tetrachloride under the conditions of Figs. 1A to 1D, the volume percentage of the oxygen in the mixture is preferably from 60% to 70% as stated before.

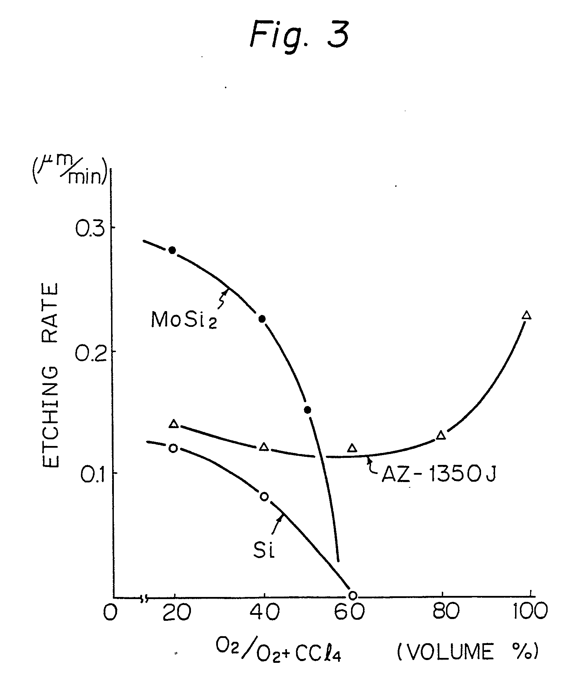

Figure 3 shows the relationship between the oxygen volume percentage in the gas mixture and the etching rate obtained by using a parallel-plate-type reaction ion etching device under the etching conditions mentioned above. The metal silicide and resist used were the same as in Fig. 1A, i.e., molybdenum silicide and AZ—1350J produced by SHIPLEY CO. As can be seen from Fig. 3, when the volume percentage of oxygen in the gas mixture is less than 50%, the molybdenum silicide layer and the silicon substrate not covered by resist can be etched. On the other hand, when the volume percentage of oxygen is 80% or more, only ashing of the resist occurs and the molybdenum silicide layer and silicon substrate are not etched.

The reason for this is thought to be that an oxide layer forms over the surface of the molybdenum silicide layer. When reactive ion etching is carried out using a volume percentage of oxygen in the gas mixture of from 60% to 70%, only the molybdenum silicide layer and the silicon substrate located around the edge of the resist layer are etched. The explanation is thought to be that a large amount of oxygen is used for oxidation of the surface of the molybdenum silicide and the ashing of the resist layer, so the volume percentage of oxygen in the gas around the edge of the resist layer becomes less than 50%, the molybdenum silicide layer under such oxygen is etched, and then the silicon substrate is etched.

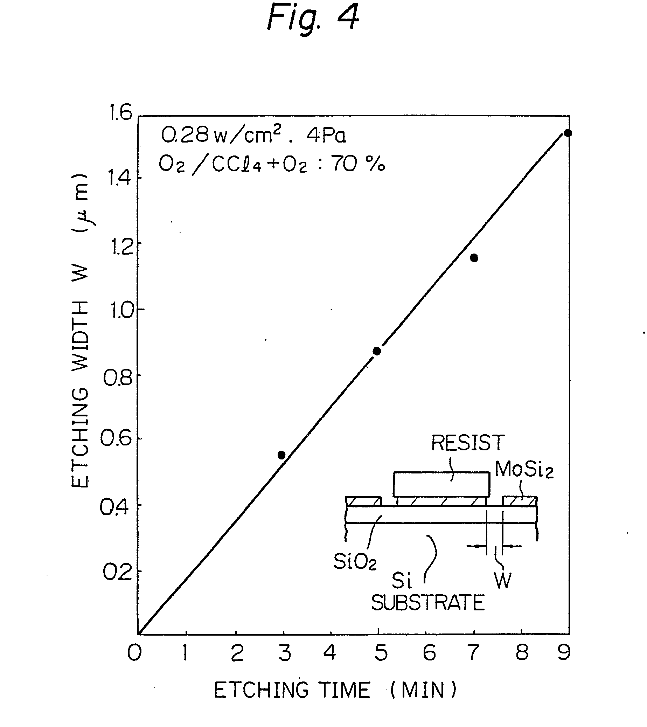

Figure 4 illustrates the relationship between the etching time and etching width at an oxygen volume of 70% in the mixture of oxygen and carbon tetrachloride, a power density of 0.28 $W/cm^2$, and a pressure of 4 Pa. This graph shows that a submicron width groove can be obtained in the silicon substrate within five minutes. Alternative processes for forming the insulating layer of the first method and the second insulating layer of the second method, so as to provide isolation regions, are now described.

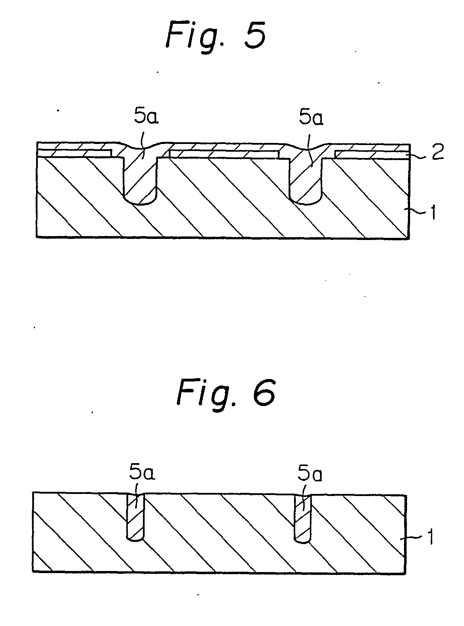

Figures 5, 6, and 7A to 7C are schematic cross-sectional views for explaining alternative processes for forming isolation regions in the grooves of the substrate.

In a first alternative, as shown in Fig. 5, after the step of Fig. 1B, only the resist layer 3 is removed. The molybdenum silicide layer 2 is left as it is. Then, a thermal oxidation process is performed under the same conditions as in the step of Fig. 1C. The silicon dioxide layer and the molybdenum silicide layer 2 over the silicon substrate 1 are removed, leaving the silicon dioxide in the groove 4 as the buried silicon dioxide regions 5a. By way of note, in this process, the molybdenum silicide layer 2 is slightly oxidized, thereby decreasing in thickness.

In a second alternative, referring to Fig. 6, after removing the resist layer 3 and the molybdenum silicide layer 2 as in Fig. 1B or after removing the insulating layer 4 from the substrate of Fig. 2D, silicon dioxide is deposited in the grooves and on the surface of the silicon substrate 1 by the CVD process. Then, the silicon dioxide layer on the surface of the silicon substrate 1 is removed to form the isolation regions 5a having a width of the grooves 4, i.e., 0.3 µm.

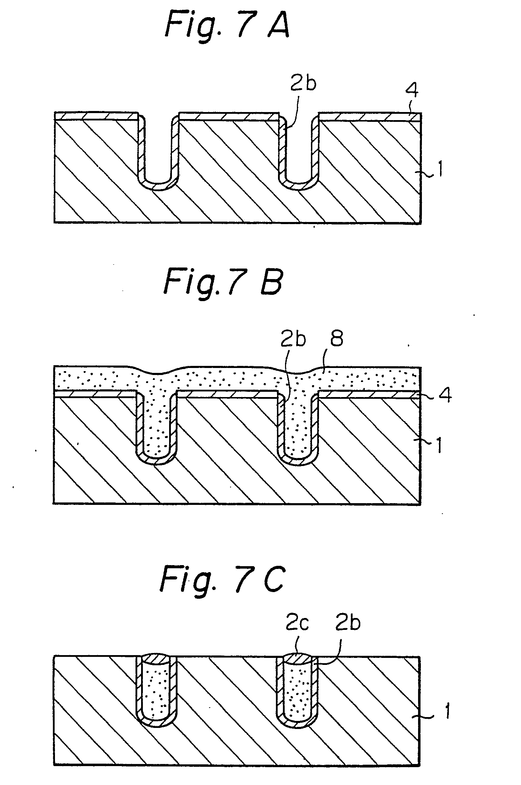

In a third alternative, referring to Figs. 7A to 7C, after removing the resist layer 3 and the molybdenum silicide layer 2 as in Fig. 1B or the step of Fig. 2D, as shown in Fig. 7A, the inner wall of the grooves in the silicon substrate 1 is slightly oxidized by a thermal oxidation process to form a silicon dioxide layer 2b.

As shown in Fig. 7B, a polycrystalline silicon layer 8 is then deposited over the silicon substrate by the well known Low Pressure CVD process to bury the grooves.

As shown in Fig. 7C, the deposited polycrystalline silicon layer 8 is removed by polishing to provide a flat surface by using the silicon nitride 4 as a mask. Alternatively anisotropic dry etching may be used to provide the flat surface. Subsequently, the exposed polycrystalline silicon above the grooves is oxidized by the thermal oxidation process to make a silicon dioxide layer 2C having a slight thickness of 0.3 μm. Then, the silicon insulating layer 4 such as silicon nitride is removed. Thus, isolation regions are produced.

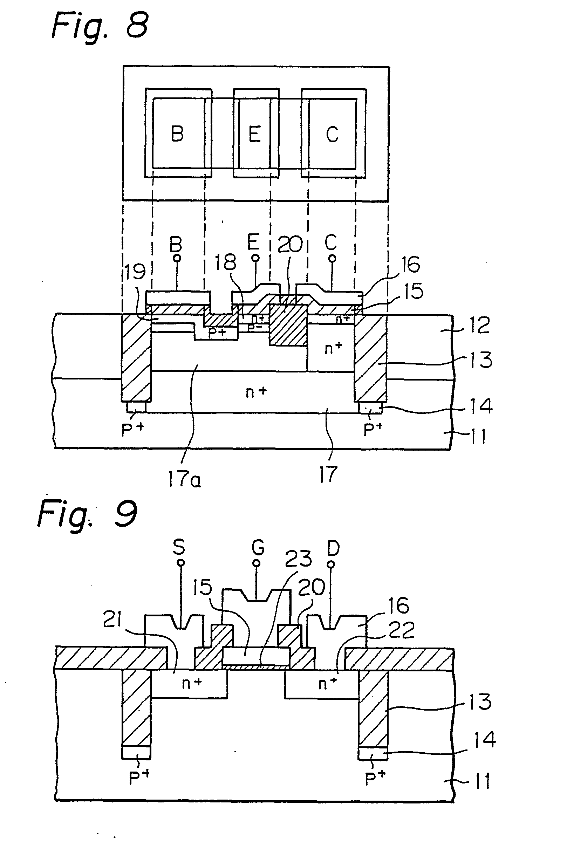

Isolation regions obtained by methods embodying the present invention can be applied to, for example, a bipolar transistor or MOS transistor. Figures 8 and 9 are schematic views for explaining applications of the present invention to a bipolar transistor and NMOS transistor, respectively.

In Figs. 8 and 9, reference numeral 11 denotes p type silicon substrate, 12 n type epitaxial silicon, 13 an isolation region, 14 a channel stopper region, 15 polycrystalline silicon, 16 aluminum, 17 an $n^+$ buried layer, 17a an n type collector region, 18 an $n^+$ region (emitter), 19 a $p^+$ region (base), 20 an insulating layer, 21 a source region, 22 a drain region, and 23 a gate insulating layer. B, E, and C denote a base, emitter, and collector, and S, D, and G denote a source, drain, and gate, respectively.

The devices shown in Figs. 8 and 9 can have a high integration density since the width of the isolation region 13 is submicron.

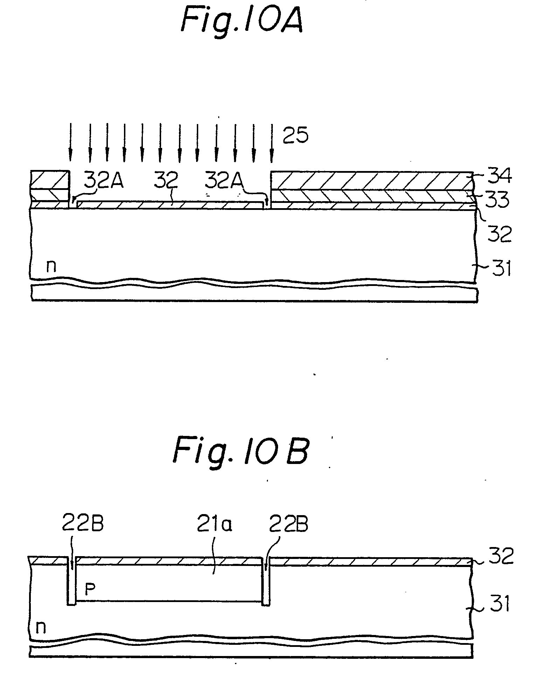

Figures 10A to 10D are views for explaining a further application of the present invention to CMOS transistors.

In Fig. 10A, substantially the same device as shown in Fig. 2B is illustrated.

Reference numeral 31 denotes an n type semiconductor substrate, 32 silicon nitride layer, 33 molybdenum silicide, 34 a resist layer, and 32A grooves having a submicron width. Boron ions 25 are implanted, and annealing is carried out to form a p type well 21a.

As shown in Fig. 10B, the grooves 32A are further etched by using the nitride layer 32 as an etching mask.

The molybdenum silicide may be removed in advance.

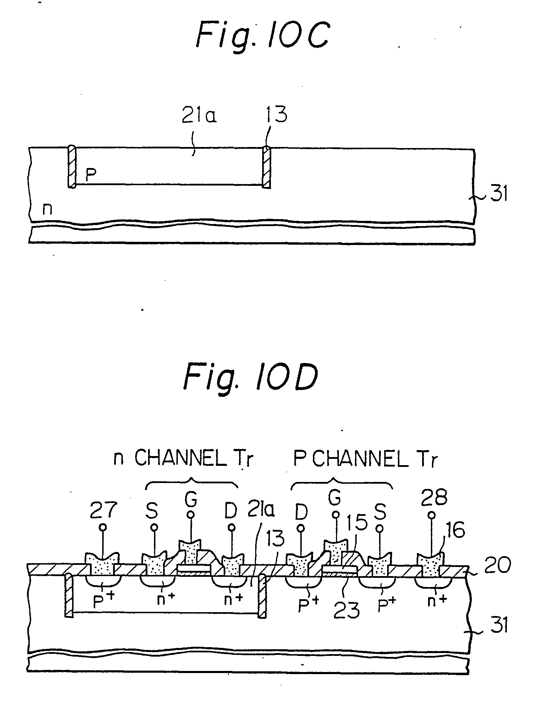

As shown in Fig. 10C, a buried insulating layer 13 is formed in grooves 22B so that the insulating layer can be self-aligned around the p-well 21a. Subsequently, as shown in Fig. 10D, a p channel transistor and an n channel transistor are formed by well known technology. In Fig. 10D, reference numerals 27 and 28 denote a p well contact and an n type substrate contact, respectively.

**Claims**

1. A method for forming an isolation region for electrically isolating elements in a semiconductor substrate, comprising the steps of:
   forming a metal or a metal silicide layer on said semiconductor substrate;
   forming a resist layer on said metal or metal silicide layer;
   forming an edge of the resist layer by patterning of the resist layer;
   selectively etching said metal or metal silicide layer and said semiconductor substrate by a reactive ion etching process using a mixture of chlorine-containing gas and oxygen gas, the relative proportions of chlorine-containing gas and oxygen gas being such that first only the metal or metal silicide layer located around the edge of the resist layer is etched, and then only the surface of the semiconductor substrate located around the edge of the resist layer is etched so as to form a groove in the surface portion of said semiconductor substrate located around the edge of said resist layer; and
   forming an insulating layer in said groove.

2. A method according to claim 1, wherein said reactive ion etching is carried out using a mixed gas of oxygen and carbon tetrachloride at a power density of 0.14 to 0.35 W/cm² and a degree of vacuum (pressure) of 1 to 10 Pa, for 3 to 30 minutes, the volume percentage of oxygen in the mixture of oxygen and carbon tetrachloride being 60% to 70%.

3. A method according to claim 1, wherein said reactive ion etching is carried out using a mixed gas of oxygen and carbon tetrachloride at a power density of 0.14 to 0.35 W/cm² and a degree of vacuum (pressure) of 1 to 10 Pa, for 1 to 9 minutes, the volume percentage of oxygen in the mixture of oxygen and carbon tetrachloride being 60% to 70%.

4. A method according to claim 1, 2 or 3, wherein said insulating layer in said groove is formed by a thermal oxidation process at a temperature of 800°C to 1100°C under a wet oxidation atmosphere.

5. A method according to claim 1, 2 or 3, wherein said insulating layer in said groove is formed by a chemical vapour deposition process.

6. A method according to claim 1, 2 or 3, wherein said insulating layer in said groove is formed by steps comprising:
   oxidizing the whole inner wall of said groove by a thermal oxidation process;
   burying said groove in polycrystalline silicon by a chemical vapour deposition process; and
   oxidizing the exposed surface of polycrystalline silicon in said groove by a thermal oxidation process.

7. A method for forming an isolation region for electrically isolating elements in a semiconductor substrate, comprising the steps of:
   forming in turn, a first insulating layer, a metal or a metal silicide layer, and resist layer;
   forming an edge of the resist layer by patterning of the resist layer;
   then, selectively etching said metal or metal silicide layer by a reactive ion etching process using a mixture of chlorine-containing gas and oxygen gas, the relative proportions of chlorine-containing gas and oxygen gas being such that only the metal or metal silicide layer located around the edge of the resist layer is etched to form a groove in the metal or metal silicide layer,

etching said first insulating layer using said metal or metal silicide layer as a masking film;

etching said semiconductor substrate using said patterned insulating layer as a masking film to form a groove in the surface portion of said semiconductor substrate; and

forming a second insulating layer in said groove.

8. A method according to claim 7, wherein said first insulating layer is selected from the group consisting of silicon nitride and silicon dioxide.

9. A method according to claims 7 or 8, wherein said reactive ion etching is carried out by using a mixed gas of oxygen and carbon tetrachloride at a power density of 0.14 to 0.35 W/cm$^2$ and a degree of vacuum of 1 to 10 Pa, for 1 to 9 minutes, the volume percentage of oxygen in the mixture of oxygen and carbon tetrachloride being 60% to 70%.

10. A method according to any of claims 7 to 9 wherein said etching of said first insulating layer to form said groove is carried out by a reactive ion etching process using an etching gas of trifluoromethane with a power density of 0.06 to 0.8 W/cm$^2$ and a degree of vacuum of 0.9 to 13 Pa, for 3 to 30 minutes.

11. A method according to any of claims 7 to 10 wherein said etching of said semiconductor substrate to form said groove is carried out by a reactive ion etching process using a mixed gas of oxygen and carbon tetrachloride at a power density of 0.14 to 0.35 W/cm$^2$ and a degree of vacuum of 1 to 10 Pa, for 3 to 30 minutes, the volume percentage of oxygen in the mixture of oxygen and carbon tetrachloride being less than 50%.

12. A method according to any of claims 7 to 11 wherein said second insulating layer in said groove is formed by a thermal oxidation process at a temperature of 800°C to 1100°C under a wet oxidation atmosphere.

13. A method according to any of claims 7 to 11, wherein said second insulating layer in said groove is formed by a chemical vapor deposition process.

14. A method according to any of claims 7 to 11, wherein said second insulating layer in said groove is formed by steps comprising:

oxidizing the whole inner wall of said groove, by a thermal oxidation process;

burying said groove in polycrystalline silicon by a chemical vapor deposition process; and

oxidizing the exposed surface of polycrystalline silicon in said groove by a thermal oxidation process.

15. A method according to any preceding claim wherein said metal is selected from the group consisting of molybdenum, tungsten, titanium, platinum and tantalum.

16. A method according to any of claims 1 to 14, wherein said metal silicide is selected from the group consisting of molybdenum silicide, tungsten silicide, titanium silicide, platinum silicide, and tantalum silicide.

17. A method according to any preceding claim wherein said chlorine-containing gas is selected from the group of carbon tetrachloride, silicon tetrachloride and boron trichloride.

**Patentansprüche**

1. Verfahren zur Bildung eines Isolationsbereiches für elektrisch isolierende Elemente in einem Halbleitersubstrat, mit den folgenden Schritten:

Bilden einer Metall- oder Metallsilizidschicht auf dem genannten Halbleitersubstrat;

Bilden einer Resistschicht auf der genannten Metall- oder Metallsilicidschicht;

Bilden eines Randes der Resistschicht durch Mustern der Resistschicht;

selektives Ätzen der genannten Metall- oder Metallsilicidschicht und des genannten Halbleitersubstrats durch ein reaktives Ionenätzverfahren, welches eine Mischung aus chlorhaltigem Gas und Sauerstoffgas enthält, wobei die relativen Proportionen des chlorhaltigen Gases und des Sauerstoffgases so sind, daß zuerst nur die Metall- oder Metallsilicidschicht, die um den Rand der Resistschicht angeordnet ist, geätzt wird, und dann nur die Oberfläche des Halbleitersubstrats, die um den Rand der Resistschicht angeordnet ist, geätzt wird, um so eine Nut in dem Oberflächenabschnitt des genannten Halbleitersubstrats um den Rand der ersten Resistschicht zu bilden; und

Bilden einer isolierenden Schicht in der genannten Nut.

2. Verfahren nach Anspruch 1, bei dem das genannte reaktive Ionenätzen unter Verwendung eines gemischten Gases aus Sauerstoff und Kohlenstofftetrachlorid bei einer Energiedichte von 0,14 bis 0,35 W/cm$^2$ und einem Vakuumgrad (Druck) von 1 bis 10 Pa 3 bis 30 Minuten lang durchgeführt wird, wobei der Volumenprozentsatz von Sauerstoff in der Mischung von Sauerstoff und Kohlenstofftetrachlorid 60% bis 70% beträgt.

3. Verfahren nach Anspruch 1, bei dem das genannte reaktive Ionenätzen unter Verwendung eines gemischten Gases aus Sauerstoff und Kohlenstofftetrachlorid bei einer Energiedichte von 0,14 bis 0,35 W/cm$^2$ und einem Vakuumgrad (Druck) von 1 bis 10 Pa 1 bis 9 Minuten lang durchgeführt wird, wobei der Volumenprozentsatz von Sauerstoff in der Mischung aus Sauerstoff und Kohlenstofftetrachlorid 60% bis 70% beträgt.

4. Verfahren nach Anspruch 1, 2 oder 3, bei dem die genannte isolierende Schicht in der genannten Nut durch einen thermischen Oxidationsverfahren bei einer Temperatur von 800°C bis 1100°C unter einer feuchten Oxidationsatmosphäre gebildet wird.

5. Verfahren nach Anspruch 1, 2 oder 3, bei dem die genannte isolierende Schicht in der genannten Nut durch ein chemisches Dampfabscheidungsverfahren durchgeführt wird.

6. Verfahren nach Anspruch 1, 2 oder 3, bei der die genannte isolierende Schicht in der genannten Nut durch Schritte gebildet wird, welche umfassen:

Oxidieren der ganzen inneren Wand der genannten Nut durch ein thermisches Oxidationsverfahren;

Vergraben der genannten Nut in einem polychristallinen Silizium durch ein chemisches Dampfabscheidungsverfahren; und

Oxidieren der genannten Oberfläche aus polykristallinem Silizium in der genannten Nut durch ein thermisches Oxidationsverfahren.

7. Verfahren zum Bilden eines Isolationsbereiches für elektrisch isolierende Elemente in einem Halbleitersubstrat, mit den folgenden Schritten:

Bilden, der Reihe nach, einer ersten isolierenden Schicht, einer Metall- oder Metallsilizidschicht und einer Resistschicht;

Bilden eines Randes der Resistschicht durch Mustern der Resistschicht;

dann, selektives Ätzen der genannten Metall- oder Metallsilicidschicht durch ein reaktives Ionenätzverfahren, welches eine Mischung aus chlorhaltigem Gas und Sauerstoffgas verwendet, wobei die relativen Proportionen des chlorhaltigen Gases und des Sauerstoffgases derart sind, daß nur die Metall- oder Metallsilicidschicht, die um den Rand der Resistschicht angeordnet ist, geätzt wird, um eine Nut in der Metall- oder Metallsilicidschicht zu bilden;

Ätzen der ersten isolierenden Schicht unter Verwendung der genannten Metall- oder Metallsilicidschicht als einem Maskenfilm;

Ätzen des genannten Halbleitersubstrats unter Verwendung der genannten gemusterten isolierenden Schicht als einem Maskenfilm, um eine Nut in dem Oberflächenabschnitt der genannten Halbleitersubstrats zu bilden; und

Bilden einer zweiten isolierenden Schicht in der genannten Nut.

8. Verfahren nach Anspruch 7, bei dem die genannte erste isolierende Schicht ausgewählt ist aus der Gruppe bestehend aus Siliziumnitrid und Siliziumdioxid.

9. Verfahren nach Anspruch 7 oder 8, bei dem das genannte reaktive Ionenätzen unter Verwendung eines gemischten Gases aus Sauerstoff und Kohlenstofftetrachlorid bei einer Energiedichte von 0,14 bis 0,35 W/cm$^2$ und einem Vakuumgrad von 1 bis 10 Pa 1 bis 9 Minuten lang durchgeführt wird, wobei der Volumen- prozentsatz des Sauerstoffes in der Mischung von Sauerstoff und Kohlenstofftetrachlorid 60% bis 70% beträgt.

10. Verfahren nach einem der Ansprüche 7 bis 9, bei dem das genannte Ätzen der genannten ersten isolierenden Schicht zur Bildung der genannten Nut durch ein reaktives Ionenätzverfahren, welches ein Ätzgas aus Trifluormethan verwendet, mit einer Energiedichte von 0,06 bis 0,8 W/cm$^2$ und einem Vakuumgrad von 0,9 bis 13 Pa 3 bis 30 Minuten lang durchgeführt wird.

11. Verfahren nach einem der Ansprüche 7 bis 10, bei dem das genannte Ätzen des genannten Halbleitersubstrats zur Bildung der genannten Nut durch ein reaktives Ionenätzverfahren, welches ein gemischtes Gas aus Sauerstoff und Kohlenstofftetrachlorid bei einer Energiedichte von 0,14 bis 0,35 W/cm$^2$ und einen Vakuumgrad von 1 bis 10 Pa verwendet, 3 bis 30 Minuten lang durchgeführt wird, wobei der Volumenprozentsatz von Sauerstoff in der Mischung von Sauerstoff und Kohlenstofftetrachlorid weniger als 50% ist.

12. Verfahren nach einem der Ansprüche 7 bis 11, bei dem die genannte zweite isolierende Schicht in der genannten Nut durch ein thermisches Oxidationsverfahren bei einer Temperatur von 800°C bis 1100°C unter feuchter Oxidationsatmosphäre durchgeführt wird.

13. Verfahren nach einem der Ansprüche 7 bis 11, bei dem die genannte zweite isolierende Schicht in der genannten Nut durch ein chemisches Dampfabscheidungsverfahren gebildet wird.

14. Verfahren nach einem der Ansprüche 7 bis 11, bei dem die genannte zweite isolierende Schicht in der genannten Nut durch Schritte gebildet wird, welche umfassen:

Oxidieren der gesamten inneren Wand der genannten Nut durch ein thermisches Oxidationsverfahren;

Vergraben der genannten Nut in polykristallinem Silizium durch ein chemisches Dampfabscheidungsverfahren; und

Oxidieren der exponierten Oberfläche des polykristallinen Siliziums in der genannten Nut durch ein thermisches Oxidationsverfahren.

15. Verfahren nach einem der vorhergehenden Ansprüche, bei dem das genannte Metall ausgewählt ist aus der Gruppe bestehend aus Molybdän, Wolfram, Titan, Platin und Tantal.

16. Verfahren nach einem der Ansprüche 1 bis 14, bei dem das genannte Metallsilizid ausgewählt ist aus der Gruppe bestehend aus Molybdänsilizid, Wolframsilizid, Titansilizid, Platinsilizid und Tantalsilizid.

17. Verfahren nach einem der vorhergehenden Ansprüche, bei dem das genannte chlorhaltige Gas ausgewählt ist aus der Gruppe aus Kohlenstofftetrachlorid, Siliziumtetrachlorid und Bortrichlorid.

## Revendications

1. Un procédé pour former une région d'isolation pour éléments isolants électriques dans un substrat semi-conducteur, comprenant les étapes suivantes:

formation d'une couche de métal ou de siliciure métallique sur ledit substrat semi-conducteur;

formation d'une couche photorésistante sur ladite couche de métal ou de siliciure métallique;

formation d'une arête de la couche photorésistante par application d'un motif à la couche photorésistante;

gravure sélective de ladite couche de métal ou de siliciure métallique et dudit substrat semi-conducteur par un procédé de gravure par ion réactif utilisant un mélange de gaz contenant du chlore et d'oxygène gazeux, les proportions relatives entre le gaz contenant du chlore et l'oxygène gazeux étant telles qu'en premier lieu seule la couche de métal ou de siliciure métallique située autour de l'arête de la couche photorésistante est gravée et qu'ensuite seulement la surface du substrat semiconducteur située autour de l'arête de la couche photorésistante est gravée pour former une gorge dans la portion de surface dudit substrat semi-conducteur située autour de l'arête de ladite couche photorésistante; et

formation d'une couche isolante dans ladite gorge.

2. Un procédé selon la revendication 1, selon lequel ladite gravure par ion réactif est conduite en utilisant un gaz mixte d'oxygène et de tétrachlorure de carbone à une densité de courant de 0,14 à 0,35 W/cm$^2$ et à un degré de vide (pression) de 1 à 10 Pa, pendant 3 à 30 min, le pourcentage en volume de l'oxygène dans le mélange d'oxygène et de tétrachlorure de carbone étant de 60% à 70%.

3. Un procédé selon la revendication 1, selon lequel ladite gravure par ion réactif est conduite en utilisant un gaz mixte d'oxygène et de tétrachlorure de carbone à une densité de courant de 0,14 à 0,35 W/cm$^2$ et à un degré de vide (pression) de 1 à 10 Pa, pendant 1 à 9 min, le pourcentage en volume d'oxygène dans le mélange d'oxygène et de tétrachlorure de carbone étant de 60% à 70%.

4. Un procédé selon la revendication 1, 2 ou 3, selon lequel ladite couche isolante dans ladite gorge est formée par un procédé d'oxydation thermique à une température de 800°C à 1100°C sous une atmosphère d'oxydation humide.

5. Un procédé selon la revendication 1, 2 ou 3, selon lequel ladite couche isolante dans ladite gorge est formée par un procédé de dépôt de vapeur chimique.

6. Un procédé selon la revendication 1, 2 ou 3, selon lequel ladite couche isolante dans ladite gorge est formée par les étapes suivantes selon lesquelles:

on oxyde la paroi interne totale de ladite gorge par un procédé d'oxydation thermique;

on enterre ladite gorge dans du silicium polycristallin par un procédé de dépôt de vapeur chimique; et

on oxyde la surface exposée du silicium polycristallin dans ladite gorge par un procédé d'oxydation thermique.

7. Un procédé pour former une région d'isolation pour éléments isolants électriques dans un substrat semi-conducteur comprenant les étapes suivantes:

formation successive d'une première couche isolante, d'une couche de métal ou de siliciure métallique, et d'une couche photorésistante;

formation d'une arête de la couche photorésistante par application d'un motif à la couche photorésistante;

ensuite, gravure sélective de ladite couche de métal ou de siliciure métallique par un procédé de gravure par ion réactif utilisant un mélange de gaz contenant du chlore et d'oxygène gazeux, les proportions relatives entre le gaz contenant du chlore et l'oxygène gazeux étant telles que seule la couche de métal ou de silicium métallique située autour de l'arête de la couche photorésistante est gravée pour former une gorge dans la couche de métal ou de siliciure métallique,

gravure de cette première couche isolante utilisant ladite couche de métal ou de siliciure métallique comme un film de masquage;

gravure dudit substrat semi-conducteur utilisant ladite couche isolante portant le motif comme un film de masquage pour former une gorge dans la portion de surface dudit substrat semiconducteur; et

formation d'une seconde couche isolante dans ladite gorge.

8. Un procédé selon la revendication 7, selon lequel ladite première couche isolante est choisie dans le groupe comprenant le nitrure de silicium et le dioxyde de silicium.

9. Un procédé selon la revendication 7 ou 8, selon lequel ladite gravure par ion réactif est conduite en utilisant un gaz mixte d'oxygène et de tétrachlorure de carbone à une densité de courant de 0,14 à 0,35 W/cm$^2$ et à un degré de vide de 1 à 10 Pa, pendant 1 à 9 min, le pourcentage en volume d'oxygène dans le mélange d'oxygène et de tétrachlorure de carbone étant de 60% à 70%.

10. Un procédé selon l'une quelconque des revendications 7 à 9, selon lequel ladite gravure de ladite première couche isolante pour former ladite gorge est conduite par un procédé de gravure par ion réactif utilisant un gaz de gravure qui est du trifluorométhane à une densité de courant de 0,06 à 0,8 W/cm$^2$ et à un degré de vide de 0,9 à 13 Pa, pendant 3 à 30 min.

11. Un procédé selon l'une quelconque des revendications 7 à 10, selon lequel ladite gravure dudit substrat semiconducteur pour former ladite gorge est conduite par un procédé de gravure par ion réactif utilisant un gaz mixte d'oxygène et de tétrachlorure de carbone à une densité de courant de 0,14 à 0,35 W/cm$^2$ et à un degré de vide de 1 à 10 Pa, pendant 3 à 30 min, le pourcentage en volume d'oxygène dans le mélange d'oxygène et de tétrachlorure de carbone étant inférieur à 50%.

12. Un procédé selon l'une quelconque des revendications 7 à 11, selon lequel ladite seconde couche isolante dans ladite gorge est formée par un procédé d'oxydation thermique à une température de 800°C à 1100°C sous une atmosphère d'oxydation humide.

13. Un procédé selon l'une quelconque des revendications 7 à 11, selon lequel ladite seconde couche isolante dans ladite gorge est formée par un procédé de dépôt de vapeur chimique.

14. Un procédé selon l'une quelconque des revendications 7 à 11, selon lequel ladite seconde couche isolante dans ladite gorge est formée par les étapes suivantes selon lesquelles:

on oxyde la paroi interne totale de ladite gorge par un procédé d'oxydation thermique;

on enterre ladite gorge dans du silicium polycristallin par un procédé de dépôt de vapeur chimique; et

on oxyde la surface exposée de silicium polycristallin dans ladite gorge par un procédé d'oxydation thermique.

15. Un procédé selon l'une quelconque des revendications précédentes, selon lequel ledit métal est choisi dans le groupe comprenant le molybdène, le tungstène, le titane, le platine et le tantale.

16. Un procédé selon l'une quelconque des revendications 1 à 14, selon lequel ledit siliciure métallique est choisi dans le groupe comprenant le siliciure de molybdène, le siliciure de tungstène, le siliciure de titane, le siliciure de platine et le siliciure de tantale.

17. Un procédé selon l'une quelconque des revendications précédentes, selon lequel ledit gaz contenant du chlore est choisi dans le groupe comprenant le tétrachlorure de carbone, le tétrachlorure de silicium et le trichlorure de bore.

*Fig. I A*

*Fig. I B*

*Fig. I C*

*Fig. I D*

## Fig. 2A

## Fig. 2 B

## Fig. 2 C

# Fig. 2 D

# Fig. 2 E

# Fig. 2 F

3

# Fig. 3

# Fig. 4

## Fig. 5

## Fig. 6

# Fig. 7 A

# Fig. 7 B

# Fig. 7 C

7

Fig. 8

Fig. 9

## Fig.10A

25

32A   32   32A   34
33
32
n   31

## Fig.10 B

22B   21a   22B
32
P
31
n

## Fig. 10 C

## Fig. 10 D